# FASCICULE DE BREVET EUROPEEN

(11) **EP 1 817 794 B1**
(45) Date de publication et mention de la délivrance du brevet: **23.07.2008**
(21) Numéro de dépôt: 05822943.6
(22) Date de dépôt: 24.11.2005
(51) Int. Cl.: H01L 23/14

(54) **SUPPORT SEMI-CONDUCTEUR RECTANGULAIRE POUR LA MICROELECTRONIQUE ET PROCEDE DE REALISATION D`UN TEL SUPPORT**
RECHTECKIGER HALBLEITERTRÄGER FÜR DIE MIKROELEKTRONIK UND HERSTELLUNGSVERFAHREN DAFÜR
RECTANGULAR SEMICONDUCTOR SUPPORT FOR MICROELECTRONICS AND METHOD FOR MAKING SAME

(30) Priorité: 30.11.2004 FR 0412699
(43) Date de publication de la demande: 15.08.2007
(73) Titulaire: COMMISSARIAT A L'ENERGIE ATOMIQUE, 75015 Paris (FR)
(72) Inventeur: DELEONIBUS, Simon, F-38640 Claix (FR)
(74) Mandataire: Jouvray, Marie-Andrée
(86) Numéro de dépôt international: PCT/FR2005/002923
(87) Numéro de publication internationale: WO 2006/058984

(56) Documents cités:
- EP-A- 0 689 244
- DE-A1- 2 536 174
- US-A- 3 961 997
- US-A- 6 099 966

## Description

### Domaine technique de l'invention

L'invention concerne un support semi-conducteur pour la microélectronique.

### État de la technique

Généralement, les supports semi-conducteurs utilisés pour la microélectronique sont circulaires et les machines de traitement des supports sont adaptées au diamètre des supports. Ainsi, lorsque le diamètre des supports est augmenté dans le but d'augmenter la productivité, il faut remplacer les machines de traitement, ce qui représente des coûts importants. De plus, la forme circulaire des supports semi-conducteurs rend difficile le traitement des supports et limite, ainsi, la vitesse de production.

Les supports semi-conducteurs sont la plupart du temps des supports en silicium. Avec ces supports, il est difficile de réaliser des composants double face, c'est-à-dire des composants comportant des éléments électroniques sur leurs deux faces, notamment leurs faces avant et arrière. Le problème principal est la tenue mécanique du silicium. En effet, un support en silicium risque de casser lorsque des éléments électroniques sont réalisés sur sec deux faces. D'autre part, le silicium présente des propriétés électroniques plus favorables à la réalisation d'éléments électroniques que des matériaux qui ont de meilleures qualités mécaniques, comme le graphite qui est utilisé, par exemple, pour des cellules solaires.

Par ailleurs, la quantité de chaleur générée par des circuits intégrés augmente avec la puissance des circuits qui ne cesse d'augmenter. Ainsi, la dissipation de la chaleur devient un problème de plus en plus important.

Le document DE 25 36 174 par SIEMENS AG divulgue un substrat rectangulaire en graphite pour les applications photovoltaïques et les dispositifs à effet de champ, supportant une couche de silicium. Lorsque le substrat en graphite sert d'électrode, le document recommande d'ajuster la température lors du dépôt du silicium sur le graphite, de manière à ce qu'une fine couche de SiC se forme automatiquement à l'interface entre le graphite et le silicium. Avec un tel substrat, l'effet d'évacuation de chaleur n'est pas assez fort.

### Objet de l'invention

L'invention a pour but de remédier à ces inconvénients et, en particulier, de proposer un support semi-conducteur, permettant d'évacuer de la chaleur, qui peut comporter des éléments électroniques sur sa face avant et sa face arrière.

Selon l'invention, ce but est atteint par les revendications annexées et, plus particulièrement, par le fait que le support semi-conducteur comporte un substrat rectangulaire en graphite ayant une face avant et une face arrière, support comportant au moins un premier empilement, disposé sur la face avant du substrat, comportant successivement une couche de diamant mono-cristalline, une couche d'oxyde électriquement isolante et une couche semi-conductrice.

L'invention a également pour but un procédé de réalisation d'un support semi-conducteur selon l'invention comportant successivement la réalisation de la couche de diamant, le dépôt de la couche d'oxyde sur la couche de diamant et la réalisation de la couche semi-conductrice.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 est une vue de dessus d'un mode de réalisation particulier d'un support semi-conducteur rectangulaire selon l'invention.
Les figures 2 et 3 représentent, en coupe selon l'axe A-A de la figure 1, deux modes de réalisation particuliers d'un support semi-conducteur rectangulaire selon l'invention.

### Description de modes particuliers de réalisation

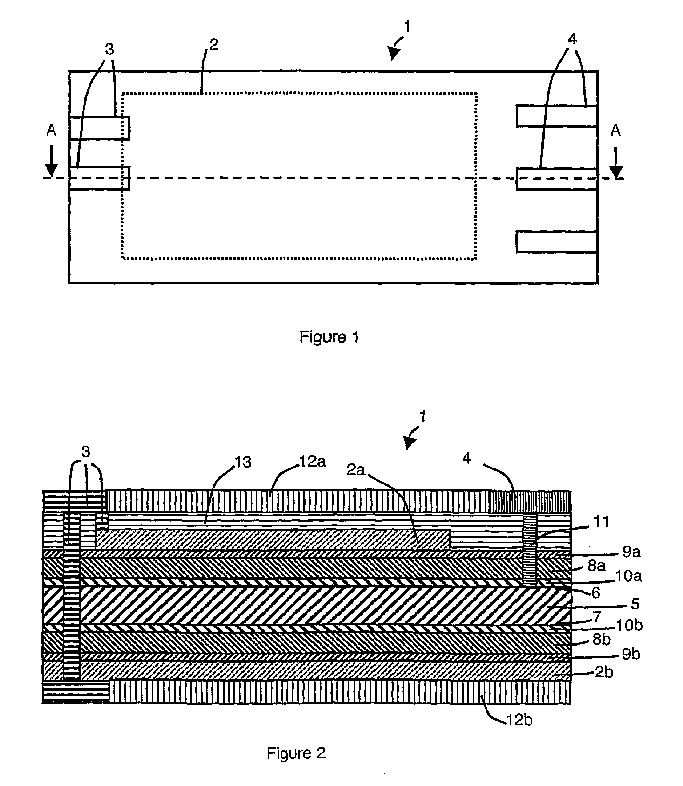

La figure 1 illustre une face avant d'un support 1 semi-conducteur rectangulaire comportant au moins un circuit intégré dans une couche semi-conductrice 2. Le circuit intégré peut être relié électriquement à la face arrière du support 1 par l'intermédiaire de connexions électriques 3 traversant le support 1. De plus, le support 1 peut comporter des radiateurs 4 disposés à une surface externe du support 1, par exemple à la face avant comme représenté, et reliés à des couches internes du support 1 par l'intermédiaire d'une connexion thermique, ce qui permet de refroidir ces couches internes lors du fonctionnement du circuit intégré. Les connexions thermiques peuvent être reliées à des sources froides externes. Le support peut également comporter des plots de connexion électrique pour relier le circuit intégré à des dispositifs externes.

Le support 1 représenté à la figure 2 comporte un substrat 5 en graphite ayant une face avant 6 et une face arrière 7, disposées respectivement en haut et en bas sur la figure 2. Le support 1 comporte un premier empilement, disposé sur la face avant 6 du substrat 5 et comportant successivement une couche de diamant 8a mono-cristalline, une couche d'oxyde 9a électriquement isolante et une couche semi-conductrice 2a. Le diamant et le graphite étant de très bons conducteurs thermiques, le support selon l'invention permet de limiter l'échauffement du support lors du fonctionnement du circuit intégré disposé dans la couche semi-conductrice 2.

Ainsi, la couche d'oxyde 9a et la couche semi-conductrice 2a constituent une structure de type SOI («Silicon On Insulator»), comportant un oxyde enterré sous un semi-conducteur.

Dans le mode de réalisation particulier représenté à la figure 2, le support 1 comporte un second empilement, disposé sur la face arrière 7 du substrat 5, comportant successivement une couche de diamant 8b mono-cristalline, une couche d'oxyde 9b électriquement isolante et une couche semi-conductrice 2b. La couche d'oxyde 9a et/ou la couche d'oxyde 9b est, de préférence, thermiquement conductrice et peut, par exemple, avoir une résistance thermique voisine de celle des couches en diamant 8a ou 8b.

Comme représenté à la figure 2, le support 1 peut comporter une couche supplémentaire 10 disposée entre le substrat 5 et les premier et/ou second empilements. Sur la figure 2, par exemple, la couche supplémentaire 10a est disposée entre le substrat 5 et la couche de diamant 8a du premier empilement et la couche supplémentaire 10b est disposée entre le substrat 5 et la couche de diamant 8b du second empilement. La couche supplémentaire 10 peut, par exemple, être isolante, par exemple en alumine, ou métallique, par exemple en nickel, en platine ou en iridium. Les couches 10a et 10b sont des couches de nucléation pour le diamant.

Les couches d'oxyde 9a et/ou 9b comportent, par exemple, un ou plusieurs des composés choisi parmi l'alumine Al2O3, le titanate de baryum et de strontium BaSrTiO3, l'oxyde de hafnium Hf02, l'oxyde de lanthane La203 et les oxydes de terres rares, par exemple les oxydes des lanthanides comme l'oxyde de lutécium Lu203 et l'oxyde de gadolinium Gd203. Dans un mode de réalisation particulier, chaque couche d'oxyde est constituée par une alternance de couches de Al2O3 et/ou de Hf02 et/ou d'un oxyde de terres rares, de façon à minimiser la densité d'états d'interface tout en conservant une bonne conductivité thermique.

Comme représenté à la figure 2, le support 1 peut comporter une connexion électrique 3 traversant le substrat 5 et reliant la couche semi-conductrice 2a du premier empilement au second empilement, par exemple à la couche semi-conductrice 2b du second empilement.

Sur la figure 2, le support 1 comporte une connexion thermique 11 traversant le premier empilement et reliant thermiquement le substrat 5 en graphite à une surface externe du support 1, notamment au radiateur 4 disposé à la face avant du support 1 et relié à la connexion thermique 11. On peut également envisager des connexions thermiques 11 traversant le second empilement et reliant thermiquement le substrat 5 à la face arrière du support 1.

Le support 1 comporte, de préférence, une couche de passivation 12 disposée sur la couche semi-conductrice 2 et assurant une protection à la fois mécanique et thermique. La couche de passivation 12 et la couche semi-conductrice 2 peuvent être séparées par une couche isolante 13 comme représenté à la figure 2 pour les couches 2a et 12a.

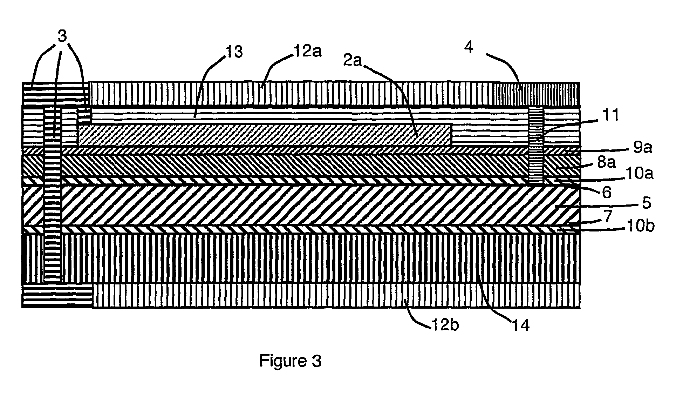

Dans le mode de réalisation particulier représenté à la figure 3, le support 1 comporte, comme précédemment, un second empilement disposé sur la face arrière 7 du substrat 5. Dans ce mode de réalisation, le second empilement comporte une couche 14 en matériau polymère, disposée entre la couche de passivation 12b et la couche supplémentaire 10b. Ceci permet d'intégrer un écran plat sur film polymère à la face arrière du support 1, la partie électronique de traitement de signal et de données étant sur la face avant du support 1, reliée avec l'écran par l'intermédiaire de connexions 3 électriques traversantes. Ainsi, peut être réalisé un micro-ordinateur très plat.

Dans un autre mode de réalisation, entre les couches 10b et 14, on peut avoir un empilement d'une couche semi-conductrice 2b et d'une couche d'oxyde 9b et, avantageusement, d'une couche de diamant 8b mono-cristalline. La couche semi-conductrice 2b a pour fonction de permettre la liaison avec un transistor d'adressage lignes-colonnes. La couche de diamant 8b mono-cristalline a pour fonction, comme la couche de diamant 8a, de refroidir des couches adjacentes.

Un procédé de réalisation d'un support 1 semi-conducteur selon l'invention comporte successivement la réalisation de la couche de diamant 8, le dépôt de la couche d'oxyde 9 sur la couche de diamant 8 et la réalisation de la couche semi-conductrice 2. La couche de diamant 8 est, par exemple, réalisée par dépôt plasma, par dépôt chimique en phase vapeur (« CVD : chemical vapor deposition ») ou par épitaxie, directement sur le substrat 5 en graphite ou sur une couche supplémentaire 10 de nucléation. Les couches de diamant 8a et 8b sont, de préférence, réalisées simultanément.

La couche semi-conductrice 2 peut être réalisée par collage moléculaire de bandes ou de feuilles de silicium rectangulaires sur la couche d'oxyde 9. Les bandes de silicium rectangulaires sont, de préférence, réalisées par une technique de type croissance de ruban sur substrat («RGS : Ribbon Growth on Substrate») ou par une technique de type échange de chaleur («HEM : Heat Exchange Method»). La technique RGS et la technique HEM sont classiquement utilisées pour la fabrication de substrats pour des cellules solaires en silicium poly-cristallin. La technique RGS consiste à déposer une bande de silicium sur un substrat à partir d'un réservoir de silicium fondu, comme décrit dans l'article « Ribbon-Growth-on-Substrate : Progress in High-Speed Crystalline Silicon Wafer Manufacturing » de A. Schönecker et Al. (29th IEEE Photovoltaic Specialists Conference, 20-24 May 2002, New Orleans, USA) et dans l'article « Ribbon-Growth-on-Substrate : Status, Challenges and Promises of High Speed Silicon Wafer Manufacturing » de A. Schönecker et Al. (12th Workshop on Crystalline Silicon Solar Cells, Materials and Processes, 2002). La technique HEM consiste à fabriquer un lingot de silicium de forme cubique à partir d'un bain de fusion, comme décrit dans l'article « Current Status of HEM Grown Silicon Ingots » de C.P. Khattak et Al. (NREL/SNL Photovoltaics Program Review Meeting, Lakeview, CO, November 1996).

Afin d'obtenir une couche semi-conductrice 2 ayant de très bonnes qualités cristallines, elle peut, par exemple, être réalisée par épitaxie par jet moléculaire («MBE : Molecular Beam Epitaxie») d'un matériau semi-conducteur ou par dépôt chimique en phase vapeur («CVD : chemical vapor deposition»). Eventuellement, on utilise un laser pour recristalliser le matériau semi-conducteur. Le matériau semi-conducteur peut, par exemple, être du silicium (Si), du germanium (Ge), du carbone diamant (C), de l'arséniure de pallium (GaAs) ou un composé comportant de l'indium et du phosphore. Ces matériaux sont avantageusement déposés sur une couche d'oxyde 9 ayant une forte constante diélectrique (« High-K »).

Les circuits intégrés peuvent ensuite être réalisés dans la couche semi-conductrice 2. Le support selon l'invention peut supporter des températures assez hautes permettant toutes techniques de réalisation de circuits intégrés.

Un support 1 comportant, à sa face arrière, une couche 14 en matériau polymère peut être réalisé à partir d'un support 1 comportant, à sa face arrière, la même succession de couches qu'à sa face avant, notamment au moins une couche de diamant 8, une couche d'oxyde 9 et une couche semi-conductrice 2. Les couches disposées à la face arrière du support 1 peuvent être enlevées par polissage de la face arrière du support 1 et la couche 14 en matériau polymère peut ensuite être déposée sur la face arrière du support 1. Lorsque le support comporte une couche supplémentaire 10b, disposée à la face arrière 7 du substrat 5, le polissage peut être arrêté sur cette couche supplémentaire 10b. Si le support ne comporte pas de couche supplémentaire 10b, une couche de nucléation, par exemple en alumine, peut être déposée sur la face arrière 7 du substrat 5, avant de déposer la couche 14 en matériau polymère.

Le polissage de la face arrière du support 1 est, de préférence, effectué par polissage mécano-chimique ou par frottement sur un tapis roulant, le support 1 étant tenu par un système d'aspiration sur le tapis roulant. La tenue mécanique du support 1 est assurée par le substrat 5 en graphite d'une épaisseur suffisante. La partie électronique peut être réalisée, avant ou après polissage, dans la couche semi-conductrice 2a disposée sur la face avant du support 1.

D'autres éléments électroniques peuvent être réalisés sur la face arrière du support 1, par exemple l'ensemble des éléments électroniques passifs nécessaires à la téléphonie mobile pour la réception, l'émission et la synthèse vocale.

Les éléments électroniques disposés sur la face arrière du support 1 sont avantageusement réalisés après mise en place de la couche de passivation 12a sur la face avant du support 1. Il est ainsi possible de retourner le support 1 et de réaliser les éléments électroniques sur la face arrière par l'intermédiaire d'étapes classiques de fabrication collective, le support 1 étant posé sur sa face avant. On ne procède à la découpe des composants qu'après réalisation de tous les éléments électroniques en face avant et arrière, de façon à minimiser les coûts de fabrication.

Le support 1 selon l'invention peut, par exemple, avoir une longueur de l'ordre de 2m et une largeur de l'ordre de 0,1m. Le support selon l'invention est, en particulier, approprié pour la réalisation de systèmes électroniques passifs ou actifs (circuits électroniques) très performants. En effet, les matériaux utilisés, comme le diamant, le graphite et l'alumine, ont une constante diélectrique inférieure à celle du silicium et, ainsi, les pertes diélectriques dues au support sont minimisées. Le coût de tels composants actifs ou passifs est alors diminué.

## Revendications

1. Support (1) semi-conducteur pour la microélectronique, comportant un substrat (5) rectangulaire en graphite ayant une face avant (6) et une face arrière (7), et au moins une couche semi-conductrice (2a) disposée sur la face avant (6) du substrat (5), support **caractérisé en ce qu'**il comporte au moins un premier empilement disposé sur la face avant (6) du substrat (5) et comportant successivement une couche de diamant (8a) mono-cristalline, une couche d'oxyde (9a) électriquement isolante ayant une forte constante diélectrique et la couche semi-conductrice (2a).

2. Support selon la revendication 1, **caractérisé en ce qu'**il comporte un second empilement, disposé sur la face arrière (7) du substrat (5), comportant successivement une couche de diamant (8b) mono-cristalline, une couche d'oxyde (9b) électriquement isolante ayant une forte constante diélectrique et une couche semi-conductrice (2b).

3. Support selon la revendication 1, **caractérisé en ce qu'**il comporte un second empilement, disposé sur la face arrière (7) du substrat (5), comportant au moins une couche en matériau polymère (14).

4. Support selon l'une quelconque des revendications 1 à 3, **caractérisé en ce qu'**il comporte au moins une connexion électrique (3) traversant le substrat (5) et reliant la couche semi-conductrice (2a) du premier empilement au second empilement.

5. Support selon l'une quelconque des revendications 1 à 4, **caractérisé en ce qu'**il comporte une couche supplémentaire (10) isolante disposée entre le substrat (5) et les premier et/ou second empilements.

6. Support selon l'une quelconque des revendications 1 à 4, **caractérisé en ce qu'**il comporte une couche supplémentaire (10) métallique disposée entre le substrat et les premier et/ou second empilements.

7. Support selon l'une quelconque des revendications 1 à 6, **caractérisé en ce que** la couche d'oxyde (9) comporte au moins un composé choisi parmi le Al2O3, le BaSrTiO3, le HfO2, le La203 et les oxydes de terres rares.

8. Support selon la revendication 7, **caractérisé en ce que** la couche d'oxyde (9) est constituée par une alternance de couches de Al2O3 et/ou de Hf02 et/ou d'un oxyde de terres rares.

9. Support selon l'une quelconque des revendications 1 à 8, **caractérisé en ce qu'**il comporte au moins une connexion thermique (11) traversant les premier et/ou second empilements et reliant le substrat (5) en graphite à une surface externe du support (1).

10. Support selon la revendication 9, **caractérisé en ce qu'**il comporte au moins un radiateur (4) disposé à la surface externe du support (1) et relié à la connexion thermique (11).

11. Support selon l'une quelconque des revendications 1 à 10, **caractérisé en ce qu'**il comporte une couche de passivation (12) disposée sur la couche semi-conductrice (2).

12. Support selon l'une quelconque des revendications 1 à 11, **caractérisé en ce qu'**au moins une des couches d'oxyde (9a, 9b) électriquement isolante est thermiquement conductrice.

13. Procédé de réalisation d'un support semi-conducteur selon l'une quelconque des revendications 1 à 12, **caractérisé en ce qu'**il comporte successivement la réalisation de la couche de diamant (8), le dépôt de la couche d'oxyde (9) sur la couche de diamant (8) et la réalisation de la couche semi-conductrice (2).

14. Procédé selon la revendication 13, **caractérisé en ce que** la couche de diamant (8) est réalisée par dépôt plasma ou par dépôt chimique en phase vapeur.

15. Procédé selon l'une des revendications 13 et 14, **caractérisé en ce que** la couche semi-conductrice (2) est réalisée par collage moléculaire de bandes de silicium rectangulaires sur la couche d'oxyde (9).

16. Procédé selon la revendication 15, **caractérisé en ce que** les bandes de silicium rectangulaires sont réalisées par une technique choisi parmi des techniques de type croissance de ruban sur substrat (RGS) et de type échange de chaleur (HEM).

17. Procédé selon l'une des revendications 13 et 14, **caractérisé en ce que** la couche semi-conductrice (2) est réalisée par épitaxie d'un matériau semi-conducteur.

18. Procédé selon l'une quelconque des revendication 13 à 17, **caractérisé en ce qu'**il comporte successivement une étape de polissage de la face arrière du support (1) et une étape de dépôt d'une couche en matériau polymère (14) sur la face arrière du support.

## Claims

1. Semi-conducting support (1) for microelectronics, comprising a rectangular graphite substrate (5) having a front surface (6) and a rear surface (7), and at least one semi-conducting layer (2a) arranged on the front surface (6) of the substrate (5), support **characterized in that** it comprises at least a first stack arranged on the front surface (6) of the substrate (5) and successively comprising a single-crystal diamond layer (8a), an electrically insulating oxide layer (9a) having a high dielectric constant and the semi-conducting layer (2a).

2. Support according to claim 1, **characterized in that** it comprises a second stack arranged on the rear surface (7) of the substrate (5), successively comprising a single-crystal diamond layer (8b), an electrically insulating oxide layer (9b) having a high dielectric constant and a semi-conducting layer (2b).

3. Support according to claim 1, **characterized in that** it comprises a second stack arranged on the rear surface (7) of the substrate (5), comprising at least one polymer material layer (14).

4. Support according to any one of the claims 1 to 3, **characterized in that** it comprises at least one electrical connection (3) passing through the substrate (5) and connecting the semi-conducting layer (2a) of the first stack to the second stack.

5. Support according to any one of the claims 1 to 4, **characterized in that** it comprises an additional insulating layer (10) disposed between the substrate (5) and the first and/or second stacks.

6. Support according to any one of the claims 1 to 4, **characterized in that** it comprises an additional metallic layer (10) disposed between the substrate and the first and/or second stacks.

7. Support according to any one of the claims 1 to 6, **characterized in that** the oxide layer (9) comprises at least one compound selected among Al2O3, BaSrTiO3, Hf02, La203 and rare earth oxides.

8. Support according to claim 7, **characterized in that** the oxide layer (9) is formed by an alternation of layers of Al2O3 and/or Hf02 and/or a rare earth oxide.

9. Support according to any one of the claims 1 to 8, **characterized in that** it comprises at least one thermal connection (11) passing through the first and/or second stacks and connecting the graphite substrate (5) to an external surface of the support (1).

10. Support according to claim 9, **characterized in that** it comprises at least one heat sink (4) arranged on the external surface of the support (1) and connected to the thermal connection (11).

11. Support according to any one of the claims 1 to 10, **characterized in that** it comprises a passivation layer (12) arranged on the semi-conducting layer (2).

12. Support according to any one of the claims 1 to 11, **characterized in that** at least one of the electrically insulating oxide layers (9a, 9b) is thermally conducting.

13. Method for making a semi-conducting support according to any one of the claims 1 to 12, **characterized in that** it successively comprises production of the diamond layer (8), deposition of the oxide layer (9) on the diamond layer (8) and production of the semi-conducting layer (2).

14. Method according to claim 13, **characterized in that** the diamond layer (8) is achieved by plasma deposition or by chemical vapor deposition.

15. Method according to one of the claims 13 and 14, **characterized in that** the semi-conducting layer (2) is achieved by molecular bonding of rectangular silicon strips onto the oxide layer (9).

16. Method according to claim 15, **characterized in that** the rectangular silicon strips are achieved by a technique selected among the Ribbon Growth on Substrate (RGS) and the Heat Exchange Method (HEM) techniques.

17. Method according to one of the claims 13 and 14, **characterized in that** the semi-conducting layer (2) is achieved by epitaxy of a semi-conducting material.

18. Method according to any one of the claims 13 to 17, **characterized in that** it successively comprises a polishing step of the rear surface of the support (1) and a deposition step of a layer of polymer material (14) on the rear surface of the support.

## Patentansprüche

1. Halbleiterträger (1) für die Mikroelektronik, der ein rechteckiges Substrat (5) aus Graphit mit einer Vorderseite (6) und einer Rückseite (7) umfasst und mindestens eine Halbleiterschicht (2a) aufweist, die auf der Vorderseite (6) des Substrats (5) angeordnet ist, Träger, der **dadurch gekennzeichnet ist, dass** er mindestens eine erste Aufschichtung umfasst, die auf der Vorderseite (6) des Substrats (5) angeordnet ist und nacheinander eine monokristalline Diamantschicht (8a), eine elektrisch isolierende Oxidschicht (9a) mit einer hohen dielektrischen Konstante und die Halbleiterschicht (2a) umfasst.

2. Träger nach Anspruch 1, **dadurch gekennzeichnet, dass** er eine zweite Aufschichtung umfasst, die auf der Rückseite (7) des Substrats (5) angeordnet ist und nacheinander eine monokristalline Diamantschicht (8b), eine elektrisch isolierende Oxidschicht (9b) mit einer hohen dielektrischen Konstante und eine Halbleiterschicht (2b) umfasst.

3. Träger nach Anspruch 1, **dadurch gekennzeichnet, dass** er eine zweite Aufschichtung umfasst, die auf der Rückseite (7) des Substrats (5) angeordnet ist und mindestens eine Schicht aus polymerem Material (14) umfasst.

4. Träger nach einem der Ansprüche 1 bis 3, **dadurch gekennzeichnet, dass** er mindestens eine elektrischen Anschluss (3) aufweist, der durch das Substrat (5) geführt ist und die Halbleiterschicht (2a) der ersten Aufschichtung mit der zweiten Aufschichtung verbindet.

5. Träger nach einem der Ansprüche 1 bis 4, **dadurch gekennzeichnet, dass** er eine zusätzliche isolierende Schicht (10) umfasst, die zwischen dem Substrat (5) und der ersten und/oder zweiten Aufschichtung vorgesehen ist.

6. Träger nach einem der Ansprüche 1 bis 4, **dadurch gekennzeichnet, dass** er eine zusätzliche Metallschicht (10) umfasst, die zwischen dem Substrat und der ersten und/oder zweiten Aufschichtung angeordnet ist.

7. Träger nach einem der Ansprüche 1 bis 6, **dadurch gekennzeichnet, dass** die Oxidschicht (9) mindestens eine Verbindung umfasst, die aus Al₂O₃, BaSrTiO₃, HfO₂, La₂O₃ und Oxiden der seltenen Erden ausgewählt ist.

8. Träger nach Anspruch 7, **dadurch gekennzeichnet, dass** die Oxidschicht (9) abwechselnd von Schichten aus Al₂O₃ und/oder HfO₂ und/oder einem Oxid seltener Erden ausgewählt ist.

9. Träger nach einem der Ansprüche 1 bis 8, **dadurch gekennzeichnet, dass** er mindestens einen thermischen Anschluss (11) aufweist, der durch die erste und/oder zweite Aufschichtung geführt ist und das Substrat (5) aus Graphit mit einer äußeren Fläche des Trägers (1) verbindet.

10. Träger nach Anspruch 9, **dadurch gekennzeichnet, dass** er mindestens einen Wärmeableiter (4) umfasst, der an der äußeren Fläche des Trägers (1) angeordnet und mit dem thermischen Anschluss (11) verbunden ist.

11. Träger nach einem der Ansprüche 1 bis 10, **dadurch gekennzeichnet, dass** er eine Passivierungsschicht (12) umfasst, die auf der Halbleiterschicht (2) angeordnet ist.

12. Träger nach einem der Ansprüche 1 bis 11, **dadurch gekennzeichnet, dass** mindestens eine der elektrisch isolierenden Oxidschichten (9a, 9b) thermisch leitend ist.

13. Verfahren zur Herstellung eines Halbleiterträgers nach einem der Ansprüche 1 bis 12, **dadurch gekennzeichnet, dass** es nacheinander die Herstellung der Diamantschicht (8), das Aufbringen der Oxidschicht (9) auf die Diamantschicht (8) und die Herstellung der Halbleiterschicht (2) umfasst.

14. Verfahren nach Anspruch 13, **dadurch gekennzeichnet, dass** die Diamantschicht (8) durch plasmaunterstütztes CVD- oder im CVD-Verfahren hergestellt wird.

15. Verfahren nach einem der Ansprüche 13 und 14, **dadurch gekennzeichnet, dass** die Halbleiterschicht (2) durch molekulares Kleben rechteckiger Siliziumstreifen auf die Oxidschicht (9) hergestellt wird.

16. Verfahren nach Anspruch 15, **dadurch gekennzeichnet, dass** die rechteckigen Siliziumscheiben mittels einer Technik hergestellt werden, die aus den Verfahren nach Art des RGS (Ribbon Growth on Substrate)-Verfahrens und des HEM (Heat Exchange Method)-Verfahrens ausgewählt ist

17. Verfahren nach einem der Ansprüche 13 und 14, **dadurch gekennzeichnet, dass** die halbleitende Schicht (2) durch Epitaxie eines halbleitenden Materials hergestellt wird.

18. Verfahren nach einem der Ansprüche 13 bis 17, **dadurch gekennzeichnet, dass** es nacheinander einen Schritt des Glattschleifens der Rückseite des Trägers (1) und einen Schritt des Aufbringens einer Schicht aus polymerem Material (14) auf die Rückseite des Trägers umfasst.
